(19) Europäisches Patentamt
European Patent Office
Office européen des brevets

(11) EP 3 033 582 B1

(12) EUROPÄISCHE PATENTSCHRIFT

(45) Veröffentlichungstag und Bekanntmachung des Hinweises auf die Patenterteilung:
**12.09.2018 Patentblatt 2018/37**

(21) Anmeldenummer: **14739189.0**

(22) Anmeldetag: **16.07.2014**

(51) Int Cl.:
*F41B 6/00* *(2006.01)*        *F16K 31/06* *(2006.01)*
*H03K 17/74* *(2006.01)*        *H03K 17/73* *(2006.01)*
*H02M 1/34* *(2007.01)*

(86) Internationale Anmeldenummer:
**PCT/EP2014/065246**

(87) Internationale Veröffentlichungsnummer:
**WO 2015/022133 (19.02.2015 Gazette 2015/07)**

(54) **VERFAHREN UND VORRICHTUNG ZUM BETREIBEN EINES INDUKTIVEN ELEMENTS**

METHOD AND DEVICE FOR OPERATING AN INDUCTIVE ELEMENT

PROCÉDÉ ET DISPOSITIF POUR FAIRE FONCTIONNER UN ÉLÉMENT INDUCTIF

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **13.08.2013 DE 102013215993**

(43) Veröffentlichungstag der Anmeldung:
**22.06.2016 Patentblatt 2016/25**

(73) Patentinhaber: **Robert Bosch GmbH**
**70442 Stuttgart (DE)**

(72) Erfinder:
• **DUKART, Anton**
**70839 Gerlingen (DE)**
• **ECKHARDT, Juergen**
**71706 Markgroeningen (DE)**

(56) Entgegenhaltungen:
**RU-C1- 2 351 064     US-A- 3 405 327**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

## Beschreibung

Stand der Technik

Die Erfindung betrifft ein Verfahren zum Betreiben eines induktiven Elements, insbesondere eines elektromagnetischen Aktors (z.B. Magnetspule eines Elektromagnets), wobei ein Kondensator vorgesehen ist, und wobei parallel zu dem Kondensator eine erste Serienschaltung aus dem induktiven Element und einer Schalteinrichtung geschaltet ist, wobei die Schalteinrichtung zu einem ersten Zeitpunkt, zu dem eine Spannung des Kondensators einen einer ersten Polarität entsprechenden ersten Kondensatorspannungswert aufweist, in einen elektrisch leitenden Zustand versetzt wird, wobei die Schalteinrichtung zu einem zweiten Zeitpunkt aus dem elektrisch leitenden Zustand in einen elektrisch nichtleitenden Zustand versetzt wird.

Die Erfindung betrifft ferner eine Vorrichtung zum Betreiben eines induktiven Elements.

Bekannte Verfahren und Vorrichtungen sehen eine sogenannte Freilaufdiode vor, welche parallel zu dem induktiven Element geschaltet ist, um einen sogenannten Abkommutierkreis zu bilden, das bedeutet, die bei dem Versetzen der Schalteinrichtung in den elektrisch nicht leitenden Zustand in dem magnetischen Feld des induktiven Elements gespeicherte Energie kontrolliert abzubauen, ohne dass Überspannungen auftreten. Nachteilig wird die abgebaute Energie hierbei in Wärmeenergie umgesetzt, belastet somit thermisch ein den Abkommutierkreis enthaltendes System, und ist dementsprechend nicht mehr für eine zukünftige elektrische Ansteuerung des induktiven Elements verfügbar.

Ferner ist es bekannt, einen Teil der im Rahmen einer Bestromung des induktiven Elements in dem induktiven Element gespeicherten Magnetfeldenergie in den Kondensator zurückzuspeisen. Hierfür sind aufwändige zusätzliche Schaltungsanordnungen erforderlich, welche die Komplexität der Vorrichtung weiter erhöhen.

Ferner ist es bekannt, einen Teil der im Rahmen einer Bestromung des induktiven Elements in dem induktiven Element gespeicherten Magnetfeldenergie in den Kondensator zurückzuspeisen. Hierfür sind aufwändige zusätzliche Schaltungsanordnungen erforderlich, welche die Komplexität der Vorrichtung weiter erhöhen.

Eine Patentschrift US 3,405,327 beschreibt ein System für eine gepulste Erregung eines Elektromagneten, welcher eine einzelne Wicklung aufweist, wobei mittels einer geschalteten Stromquelle ein Kondensator auf einen ersten Spannungspegel aufgeladen wird.

Eine Druckschrift RU 2 351 064 C1 beschreibt eine Erfindung für eine Vorrichtung und für ein Verfahren, welche zur Impulserzeugung von elektromagnetischen Aktoren verwendbar ist.

Offenbarung der Erfindung

Demgemäß ist es Aufgabe der vorliegenden Erfindung, ein Verfahren und eine Vorrichtung der eingangs genannten Art dahingehend zu verbessern, dass eine zumindest teilweise Wiedergewinnung bzw. -verwendung (z.B. für eine nachfolgende elektrische Ansteuerung) der in dem Magnetfeld des induktiven Elements gespeicherten Energie möglich ist bei gleichzeitig vergleichsweise geringer schaltungstechnischer Komplexität.

Diese Aufgabe wird bei dem Verfahren der eingangs genannten Art erfindungsgemäß dadurch gelöst, dass der zweite Zeitpunkt so gewählt ist, dass die Kondensatorspannung in einem zwischen dem ersten und dem zweiten Zeitpunkt liegenden Zeitintervall mindestens n-mal ihre Polarität wechselt, wobei n > 1 ist.

Das bedeutet, eine "Ansteuerung" des induktiven Elements, welche durch einen elektrisch leitenden Zustand der Schalteinrichtung gekennzeichnet ist, wird erfindungsgemäß so lange zwischen dem ersten und dem zweiten Zeitpunkt aufrechterhalten, dass die Kondensatorspannung des eine elektrische Energie zur Ansteuerung des induktiven Elements liefernden Kondensators ihre Polarität in dem betreffenden Zeitintervall mindestens zweimal (n>1) wechselt. Erfindungsgemäß wird hierbei vorteilhaft die Tatsache ausgenutzt, dass bei einer Bestromung des induktiven Elements aus dem Kondensator zunächst der durch das induktive Element fließende Strom gemäß den bekannten physikalischen Gesetzmäßigkeiten auf seinen Maximalwert ansteigt. Dies ist damit gleichbedeutend, dass eine vor dem Beginn der Ansteuerung des induktiven Elements in dem Kondensator gespeicherte elektrische Energie nunmehr vollständig (ggf. abzüglich ohmscher Verluste) in dem Magnetfeld des induktiven Elements gespeichert ist ($W = \frac{1}{2} * L * i^2$). Sofern dem erfindungsgemäßen Prinzip folgend der zweite Zeitpunkt so gewählt wird, dass er nach demjenigen Zeitpunkt liegt, zu dem die gesamte elektrische Energie in dem Magnetfeld des induktiven Elements gespeichert ist, besteht demnach die Möglichkeit, wenigstens einen Teil der Energie, welche in an sich bekannter Weise nunmehr von dem induktiven Element - über die immer noch geschlossene Schalteinrichtung - in den Kondensator zurückfließt, wieder zu nutzen. Hierzu wird die in Serie zu dem induktiven Element geschaltete Schalteinrichtung so lange in ihrem elektrisch leitenden Zustand belassen, bis die an dem Kondensator anliegende Spannung - ausgehend von der ersten Polarität vor dem Beginn der Ansteuerung - mindestens zweimal ihre Polarität wechselt. Wenn beispielsweise die Schalteinrichtung bei einem solchen zweiten Zeitpunkt in ihren nicht leitenden Zustand versetzt wird, zu dem der Betrag der Kondensatorspannung maximal ist, kann ein Großteil der zuvor während der Ansteuerung des induktiven Elements in dem Magnetfeld des induktiven Elements gespeicherten elektrischen Energie erneut verwendet werden, da diese nunmehr wiederum in dem Kondensator gespeichert ist, jedoch ggf. mit im Vergleich zu dem Ausgangszustand (vor Ansteuerbeginn) umgekehrter Polarität.

Beispielsweise kann bei einer Ausführungsform also der Zeitpunkt so gewählt werden, dass er in etwa übereinstimmt mit demjenigen Zeitpunkt, zu dem der Betrag der Kondensatorspannung nach dem Abbau des Magnetfelds aus dem induktiven Element maximal geworden ist. Dieser Zeitpunkt kann beispielsweise direkt an der Kondensatorspannung, bevorzugt jedoch im Wege einer Strommessung des durch das induktive Element fließenden Stroms erkannt werden.

Sofern das erfindungsgemäß betriebene induktive Element in einem Zielsystem eingesetzt wird, bei dem es nicht von Bedeutung ist, welche Polarität die für die Ansteuerung des induktiven Elements verwendete Kondensatorspannung eingangs einer Ansteuerung des induktiven Elements aufweist (z.B. Aktor nach dem Wirbelstromprinzip), kann eine zweite Ansteuerung des induktiven Elements unmittelbar nach dem Rückspeisen der Energie aus dem Magnetfeld des induktiven Elements in den Kondensator erfolgen. In diesem Fall wird die zweite Ansteuerung des induktiven Elements durch neuerliches Schließen, d.h. in den leitfähigen Zustand versetzen, der Schalteinrichtung bewirkt. In diesem Fall fließt, nunmehr getrieben durch eine Kondensatorspannung mit zweiter Polarität, die entgegengesetzt zu der ersten Polarität ist, erneut ein Strom durch das induktive Element, und so fort.

Bei einer besonders bevorzugten Ausführungsform ist der zweite Zeitpunkt so gewählt, dass für das zweite Zeitintervall gilt: 0,7 * T_LC2 <= T_12 <= 1,3 * T_LC2, wobei T_12 der Wert des zweiten Zeitintervalls ist, wobei $T\_LC2 = \pi\sqrt{LC}$, wobei L ein Induktivitätswert des induktiven Elements ist, und wobei C ein Kapazitätswert des Kondensators ist. In diesem Fall ist eine optimale "Rückgewinnung" der für die Ansteuerung des induktiven Elements verwendeten elektrischen Energie im Rahmen einer Rückspeisung in den Kondensator ermöglicht.

Besonders vorteilhaft ist vorgesehen, dass der zweite Zeitpunkt so gewählt ist, dass die Kondensatorspannung in dem Zeitintervall mindestens zwei Mal ihre Polarität wechselt. Dadurch kann die zunächst in dem Kondensator gespeicherte elektrische Energie zur Ansteuerung des induktiven Elements während der Ansteuerung zunächst auf das induktive Element übergehen, schließlich wieder zurück schwingen auf den Kondensator (nun mit umgekehrter Polarität bezüglich des Ausgangszustands). Durch die nach wie vor in leitfähigem Zustand verbleibende Schalteinrichtung kann die elektrische Energie nunmehr mit zweiter Polarität aus dem Kondensator wiederum in das induktive Element verbracht werden, schließlich von dem induktiven Element erneut in den Kondensator zurückfließen, nun jedoch mit der ersten Polarität, wie sie vor dem Beginn der Ansteuerung gegeben war. Hierbei wechselt die Kondensatorspannung mithin zwei Mal ihre Polarität in dem betrachteten Zeitintervall.

In diesem Fall wird die Schalteinrichtung also erst dann wieder in den nicht leitenden Zustand versetzt bzw. der zweite Zeitpunkt so gewählt, dass die Energie von dem Kondensator auf das induktive Element, von dem induktiven Element auf den Kondensator (umgekehrte Polarität), von dem Kondensator auf das induktive Element und wieder von dem induktiven Element zurück auf den Kondensator schwingen kann. Erst dann wird die Schalteinrichtung wieder in ihren nicht leitenden Zustand versetzt, wodurch der zweite Zeitpunkt definiert ist. Nach einer derartigen Ansteuerung ist der Kondensator wiederum auf eine elektrische Spannung aufgeladen, welche der durch das erfindungsgemäße Verfahren zurückgewonnenen Energie entspricht. Die zurückgewonnene Energie entspricht betragsmäßig in etwa der zu Ansteuerbeginn in dem Kondensator gespeicherten elektrischen Energie abzüglich der ohmschen Verluste während der Ansteuerung des induktiven Elements, der Umladung des Kondensators auf die zweite Polarität, und des erneuten Beaufschlagens des induktiven Elements bzw. des erneuten Aufladens des Kondensators mit der ersten Polarität, ggf. ferner abzüglich einer bei der Ansteuerung des induktiven Elements erhaltenen mechanischen Energie.

Bei einer weiteren Ausführungsform der Erfindung kann eine Schaltungsanordnung zum Kommutieren des Kondensators vorgesehen sein, sodass der zweite Zeitpunkt so gewählt werden kann, dass die Kondensatorspannung beispielsweise nur einmal ihre Polarität wechselt. Danach steht die zurückgewonnene elektrische Energie - mit zweiter Polarität - in dem Kondensator zur Verfügung. Sofern eine neuerliche Ansteuerung des induktiven Elements mit einer Ansteuerspannung der ersten Polarität gewünscht ist, kann durch die bei der vorliegenden Ausführungsform vorgesehene Kommutierungsschaltung die Schaltung bzw. Polarität des Kondensators bezüglich des induktiven Elements invertiert werden, so dass der vorstehend beschriebene Polaritätswechsel kompensiert wird.

Bei einer weiteren vorteilhaften Ausführungsform ist vorgesehen, dass der zweite Zeitpunkt so gewählt ist, dass für das zweite Zeitintervall gilt: 0,8 * T_LC <= T_12 <= 1,2 * T_LC, wobei T_12 der Wert des zweiten Zeitintervalls ist, wobei T_LC = $2\pi\sqrt{LC}$, wobei L ein Induktivitätswert des induktiven Elements ist, und wobei C ein Kapazitätswert des Kondensators ist, wobei der zweite Zeitpunkt insbesondere so gewählt ist, dass 0,875 * T_LC <= T_12 <= 1,125 * T_LC.

Bei einer weiteren vorteilhaften Ausführungsform ist vorgesehen, dass der zweite Zeitpunkt so gewählt ist, dass ein Betrag des zu dem zweiten Zeitpunkt durch den Kondensator fließenden Stroms einen vorgebbaren Schwellwert unterschreitet, beispielsweise etwa 10 % eines Maximalwerts des Stroms.

Bei einer weiteren vorteilhaften Ausführungsform ist vorgesehen, dass der zweite Zeitpunkt so gewählt ist, dass ein Betrag der zu dem zweiten Zeitpunkt an dem Kondensator anliegenden Spannung einen vorgebbaren Schwellwert überschreitet, beispielsweise etwa 20 % einer Ausgangsspannung des Kondensators zu dem Beginn der Ansteuerung.

Die vorstehenden Kriterien verwenden relativ einfach zu ermittelnde elektrische Größen, um den zweiten Zeitpunkt festzulegen.

Bei einer weiteren vorteilhaften Ausführungsform ist vorgesehen, dass mindestens ein weiterer Schaltungszweig parallel zu dem Kondensator geschaltet ist, wobei der mindestens eine weitere Schaltungszweig wenigstens ein weiteres induktives Element aufweist und eine hierzu elektrisch in Serie geschaltete weitere Schalteinrichtung. Dadurch kann die in der Schaltung zwischen Kondensator und induktiven Elementen hin- und herschwingende Energie mehr als einen induktiven Pfad verwenden, wodurch u.a. eine Zeitkonstante für eine Umladung des Kondensators beeinflussbar ist. Auch kann dadurch ggf. ein Stromfluss durch das induktive Element des Aktors bei zweiter (also negativer) Polarität der Kondensatorspannung vermieden werden. Mit anderen Worten kann für ein Zurückschwingen der Energie aus dem Kondensator allein das weitere induktive Element verwendet werden, so dass das induktive Element des Aktors hierfür nicht bestromt werden muss. Sofern für das weitere induktive Element ein anderer Induktivitätswert gewählt wird als bei dem induktiven Element des Aktors, kann ferner das Zeitverhalten für das Zurückschwingen der Energie beeinflusst werden.

Bei einer weiteren vorteilhaften Ausführungsform ist vorgesehen, dass die weitere Schalteinrichtung a) in einen elektrisch nichtleitenden Zustand versetzt wird, wenn die Kondensatorspannung die erste Polarität aufweist, und/oder b) zumindest zeitweise, in einen elektrisch leitenden Zustand versetzt wird, wenn die Kondensatorspannung eine zweite, von der ersten Polarität verschiedene Polarität, aufweist. Durch Variante a) ist sichergestellt, dass die gesamte in dem Kondensator gespeicherte Energie dem primären induktiven Element des Aktors zugeleitet wird. Durch Variante b) kann gesteuert werden, inwieweit das zweite induktive Element für eine neuerliche Umladung des Kondensators verwendet wird (ggf. zusätzlich zu dem ersten induktiven Element des Aktors).

Besonders vorteilhaft ist die Verwendung des erfindungsgemäßen Verfahrens zur Ansteuerung eines Einspritzventils insbesondere eines Kraftfahrzeugs.

Weitere Merkmale, Anwendungsmöglichkeiten und Vorteile der Erfindung ergeben sich aus der nachfolgenden Beschreibung von Ausführungsbeispielen der Erfindung, die in den Figuren der Zeichnung dargestellt sind. Dabei bilden alle beschriebenen oder dargestellten Merkmale für sich oder in beliebiger Kombination den Gegenstand der Erfindung, unabhängig von ihrer Zusammenfassung in den Patentansprüchen oder deren Rückbeziehung sowie unabhängig von ihrer Formulierung bzw. Darstellung in der Beschreibung bzw. in der Zeichnung.

In der Zeichnung zeigt:

Figur 1     schematisch eine erste Ausführungsform einer erfindungsgemäßen Vorrichtung,

Figur 2     schematisch eine zweite Ausführungsform einer erfindungsgemäßen Vorrichtung,

Figur 3     schematisch ein Zeitdiagramm verschiedener Betriebsgrößen einer Ausführungsform,

Figur 4     schematisch eine Schaltungsanordnung gemäß einer weiteren Ausführungsform,

Figur 5a - 5d     schematisch eine weitere Ausführungsform in unterschiedlichen Betriebszuständen,

Figur 6     schematisch ein vereinfachtes Flussdiagramm einer Ausführungsform des erfindungsgemäßen Verfahrens, und

Figur 7     schematisch ein vereinfachtes Flussdiagramm einer weiteren Ausführungsform des erfindungsgemäßen Verfahrens.

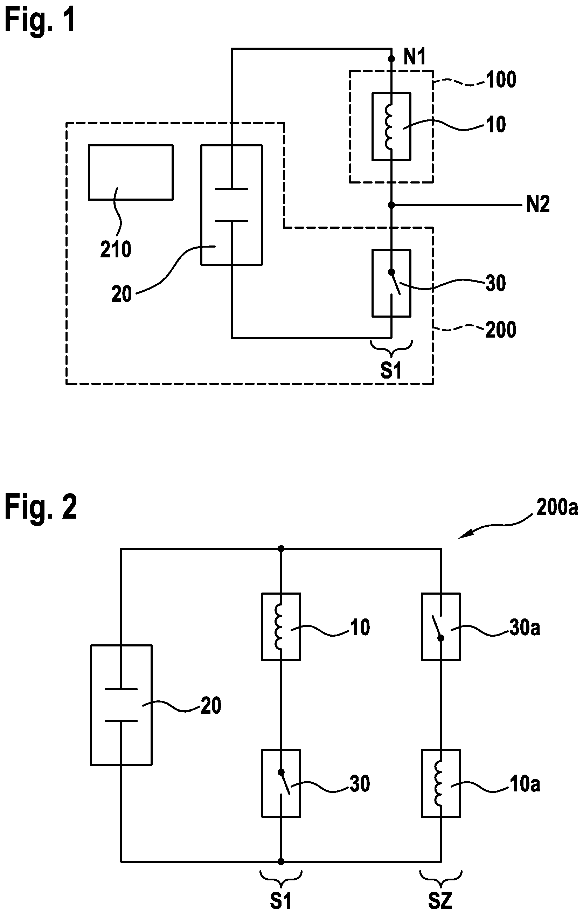

Figur 1 zeigt schematisch eine Ausführungsform einer erfindungsgemäßen Vorrichtung 200 zum Betreiben eines induktiven Elements 10. Das induktive Element 10 kann beispielsweise Bestandteil eines elektromagnetischen Aktors 100 sein, wie er beispielsweise in Einspritzventilen für Fluide zur Betätigung eines oder mehrerer beweglicher Elemente des Einspritzventils verwendet wird.

Bei einer bevorzugten Ausführungsform ist das induktive Element 10 durch eine Magnetspule des elektromagnetischen Aktors 100 gebildet.

Elektrische Energie zur Ansteuerung des induktiven Elements 10 wird bevorzugt in einem kapazitiven Element 20, das beispielsweise einen oder mehrere Kondensatoren enthalten kann, bereitgestellt. Die Vorrichtung 200 verfügt ferner über eine Schalteinrichtung 30, welche wahlweise in einen elektrisch leitenden Zustand und in einen elektrisch nicht leitenden Zustand versetzt werden kann. Wie aus Figur 1 ersichtlich bilden das induktive Element 10 und die Schalteinrichtung 30 vorliegend eine Serienschaltung S1, die parallel zu dem kapazitiven Element 20 geschaltet ist.

Eine Ansteuerung der Schalteinrichtung 30 erfolgt beispielsweise durch eine Steuereinrichtung 210 der Vorrichtung 200. Die Steuereinrichtung 210 kann beispielsweise einen Zustandsautomaten, realisiert durch diskrete Logikbauelemente oder auch programmierbare Logikbausteine oder dergleichen, aufweisen. Alternativ oder ergänzend kann die Funktionalität der Steuereinrichtung 210 auch durch einen Mikrocontroller oder einen digitalen Signalprozessor (DSP) oder dergleichen gebildet werden.

In an sich bekannter Weise kann eine Bestromung des induktiven Elements 10 dadurch eingeleitet werden, dass die Schalteinrichtung 30 ausgehend von einem nicht elektrisch leitenden Zustand in den elektrisch leitenden Zustand versetzt wird. Die Bestromung kann beendet werden, indem die Schalteinrichtung 30 von ihrem elektrisch leitenden Zustand in einen nicht elektrisch leitenden Zustand versetzt wird.

Dabei definiert ein erster Zeitpunkt einen Ansteuerbeginn. Hierbei weist die Spannung des Kondensators 20 einen einer ersten Polarität entsprechenden ersten Kondensatorspannungswert auf. Durch Schließen der Schalteinrichtung 30 wird demnach die Kondensatorspannung an das induktive Element 10 angelegt, und es stellt sich ein Stromfluss durch das induktive Element 10 ein. Erfindungsgemäß wird die Schalteinrichtung 30 so lange in ihrem elektrisch leitfähigen Zustand belassen, bis die Kondensatorspannung in einem zwischen dem ersten und einem zweiten Zeitpunkt liegenden Zeitintervall mindestens einmal ihre Polarität wechselt. Dies ist damit gleichbedeutend, dass zumindest ein Teil der zunächst in dem Kondensator 20 gespeicherten elektrischen Energie, welche im Rahmen der Bestromung der induktiven Elements 10 auf das induktive Element übergeht, wiederum in den Kondensator 20 zurückfließt und auf diese Weise für eine erneute Ansteuerung zurückgewonnen wird.

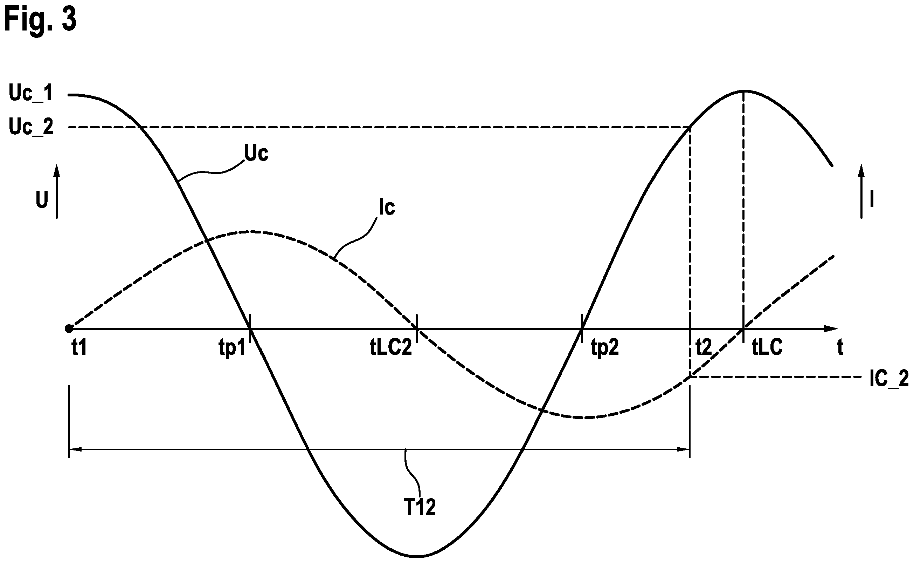

Figur 3 zeigt hierzu ein Zeitdiagramm der Kondensatorspannung Uc und des Kondensatorstroms Ic. Zu einem ersten Zeitpunkt t1 ist der Kondensator 20 auf eine Ausgangsspannung Uc_1 aufgeladen. Sobald die Schalteinrichtung 30 in ihren leitfähigen Zustand versetzt wird, entlädt sich der Kondensator 20 in an sich bekannter Weise, und der Kondensatorstrom Ic und damit auch der Strom durch das induktive Element 10 steigt an. Insoweit entspricht der Betrieb der erfindungsgemäßen Vorrichtung 200 einem L-C-Parallelschwingkreis.

Erfindungsgemäß wird der zweite Zeitpunkt t2, zu dem die Schalteinrichtung 30 ausgehend von dem ersten Zeitpunkt t1 erstmals wieder in ihren elektrisch nicht leitenden Zustand versetzt wird so gewählt, dass mindestens ein Wechsel der Polarität der Kondensatorspannung auftritt. Der Zeitpunkt des ersten Polaritätswechsels der Kondensatorspannung Uc nach dem ersten Zeitpunkt t1 ist im Zeitdiagramm gemäß Figur 3 mit dem Bezugszeichen tp1 markiert. Zu dem Zeitpunkt tp1 ist die gesamte elektrische Ansteuerenergie der Vorrichtung 200 (abzüglich ohmscher Verluste und ggf. Wirkleistungsentnahme durch den Aktor 100) in dem Magnetfeld des induktiven Element 10 gespeichert, und der Kondensator 20 ist vollständig entladen. Anschließend, d.h. nach dem Zeitpunkt tp1, wird der Kondensator 20 getrieben durch den Strom durch das induktive Element 10 wieder aufgeladen, jedoch mit einer zu der Ausgangsspannung Uc_1 inversen Polarität. In gleichem Maße verringert sich der Kondensatorstrom Ic, der aufgrund der in Figur 1 abgebildeten Schaltungstopologie in dem vorstehend bezeichneten Betriebszustand identisch ist mit dem Strom durch das induktive Element 10.

Zu dem Zeitpunkt tLC2 ist der Kondensator 20 vollständig mit inverser Polarität aufgeladen. Bei einer Ausführungsform der Erfindung kann bereits zu diesem Zeitpunkt tLC2 die Schalteinrichtung 30 nicht leitend geschaltet werden, so dass die elektrische Energie des Kondensators 20 für eine neuerliche Ansteuerung des induktiven Elements 10 verwendbar ist. Dies ist beispielsweise dann denkbar, wenn für die nachfolgende Ansteuerung des induktiven Elements 10 unerheblich ist, welche Polarität die zur Ansteuerung verwendete Kondensatorspannung Uc aufweist.

Gegenüber herkömmlichen Systemen, bei denen die während einer Ansteuerung eines induktiven Elements aufgebaute Magnetfeldenergie durch konventionelle Freilaufdioden abgebaut und damit dissipiert wird, ermöglicht das erfindungsgemäße Prinzip vorteilhaft die Rückgewinnung eines größtmöglichen Anteils der ursprünglich in dem Kondensator 20 gespeicherten Ansteuerenergie. Falls für eine nachfolgende, zweite Ansteuerung des induktiven Elements 10 jedoch nicht unerheblich ist, welche Polarität die ansteuernde Kondensatorspannung Uc aufweist, kann erfindungsgemäß vorteilhaft die Schalteinrichtung 30 ausgehend von dem Zeitpunkt tLC2 gemäß Figur 3 weiterhin in ihrem elektrisch leitenden Zustand belassen werden. In diesem Fall entlädt sich der Kondensator 20 erneut in das induktive Element 10, wobei die gesamte elektrische Energie zu dem Zeitpunkt tp2 in dem induktiven Element 10 gespeichert ist. Nach dem Zeitpunkt tp2 lädt sich dementsprechend der Kondensator 20 wieder auf, weil das induktive Element 10 weiter einen Strom in den Kondensator 20 treibt. Die Aufladung ab dem Zeitpunkt tp2 gemäß Figur 3 erfolgt dabei jedoch wiederum mit der Ausgangspolarität, d.h. der ersten Polarität (Uc > 0) so dass hiernach der Kondensator 20 wieder auf die Ausgangsspannung UC_1 aufgeladen ist. Bei der vorstehenden Beschreibung werden ohmsche Verluste, wie sie in realen Bauelementen 10, 20, 30 auftreten, vernachlässigt, weswegen die Kondensatorspannung zu dem Zeitpunkt tLC etwa der Ausgangsspannung UC_1 gleichgesetzt werden kann. Ferner liegt der in Figur 3 abgebildeten Darstellung die Annahme zugrunde, dass keine Wirkleistung durch den Aktor 100 entnommen wird. Sofern Wirkleistung während der Ansteuerung des induktiven Elements 10 durch den Aktor 100 verrichtet wird, gestaltet sich die Energiebilanz des erfindungsgemäßen Systems derart anders, dass eine Rückspeisung mit verminderter Spannung auf den Kondensator 20 möglich ist. Dieser Sachverhalt ist in Figur 3 der Übersichtlichkeit halber jedoch nicht dargestellt.

Bei einer besonders bevorzugten Ausführungsform wird der zweite Zeitpunkt t2, zu dem die Schalteinrichtung 30 erstmals ab dem Zeitpunkt t1 wieder in ihren nicht leitenden Zustand versetzt wird, daher möglichst so gewählt, dass die Ansteuerdauer T12 bzw. das betreffende Zeitintervall etwa der Schwingungszeitkonstante TLC des durch die Komponenten 10, 20 gebildeten L-C-Parallelschwingkreises entspricht. In diesem Fall ist eine maximale Rückgewinnung der elektrischen Ansteuerenergie möglich, so dass zu dem Zeitpunkt TLC gemäß Figur 3 eine erneute Ansteuerung des induktiven Elements 10 vorgenommen werden kann.

Wie bereits vorstehend beschrieben, wird durch die Entnahme von Wirkleistung bei der Ansteuerung des induktiven Elements 10 sowie durch parasitäre ohmsche Verluste der Vorrichtung während des Ansteuerintervalls T12 Energie entnommen, so dass für eine zweite Ansteuerung zunächst weniger Energie in dem Kondensator 20 bereitsteht als beispielsweise für die erste Ansteuerung.

Diesem Effekt kann durch eine Versorgungsschaltung, die in Figur 1 nicht gezeigt ist, entgegengewirkt werden. Die Versorgungsschaltung kann beispielsweise ebenfalls durch die Steuereinrichtung 210 gesteuert werden und beispielsweise bei Bedarf den Kondensator 20 erneut auf die Ausgangsspannung UC_1 aufladen.

Figur 2 zeigt schematisch eine weitere Ausführungsform 200a der erfindungsgemäßen Vorrichtung. Zusätzlich zu der Serienschaltung S1 der Komponenten 10, 30 ist ein weiterer Schaltungszweig SZ vorgesehen, der bevorzugt als Serienschaltung eines weiteren induktiven Elements 10a und einer weiteren Schalteinrichtung 30a ausgebildet ist.

Bei einer bevorzugten Ausführungsform ist die Schalteinrichtung 30a nicht leitend geschaltet, während der Kondensator 20 die erste Polarität aufweist. In diesem Fall wird bei einem Schließen der Schalteinrichtung 30 der Kondensator 20 wie vorstehend bereits beschrieben allein über das induktive Element 10 entladen, um dieses anzusteuern.

Bei einer bevorzugten Ausführungsform wird die weitere Schalteinrichtung 30a leitend geschaltet, wenn die Kondensatorspannung 20 und damit auch die an der Serienschaltung S1 abfallende Spannung eine negative Polarität aufweist. Dadurch kann die in dem Kondensator 20 (bei negativer Polarität) gespeicherte Energie durch beide Schaltungszweige S1, SZ in die betreffenden induktiven Elemente 10, 10a zurückschwingen und von diesen induktiven Elementen 10, 10a wiederum auf den Kondensator 20 fließen (bei erster Polarität).

In diesem Fall teilt sich der Stromfluss in einer Betriebsphase, beispielsweise ab dem Zeitpunkt tLC2 gemäß Figur 3, auf die beiden Schaltungszweige S1, SZ. Dadurch kann beispielsweise eine zu starke Bestromung des Aktors 100 in dieser Betriebsphase und damit ggf. eine unerwünschte Ansteuerung mit der negativen Polarität vermieden werden. Vielmehr dient nun zusätzlich das zweite induktive Element 10a als temporärer elektrischer Energiespeicher, um eine erneute Umladung des Kondensators 20 auf die Ausgangspolarität, also die erste Polarität, zu ermöglichen.

Alternativ kann für Betriebszustände mit negativer Kondensatorspannung (Uc < 0) auch nur die zweite Schalteinrichtung 30a leitend geschaltet werden, um ein Rückschwingen der Energie aus dem Kondensator 20 über das Element 10a wieder in den Kondensator 20 (nun mit erster Polarität) zu ermöglichen. In diesem Fall wird die erste Schalteinrichtung 30 dabei nichtleitend geschaltet, sodass gar keine Bestromung des Aktors 100 mit negativer Polarität auftritt. Mit anderen Worten kann bei einer weiteren Ausführungsform der Erfindung auch vorgesehen sein, dass ein Umladevorgang ab dem Zeitpunkt beispielsweise tLC2 gemäß Figur 3 allein über den weiteren Schaltungszweig SZ erfolgt. In diesem Fall ist die Schalteinrichtung 30 des Schaltungszweigs S1 für diese Betriebsphase hochohmig zu schalten, so dass kein Strom über den Schaltungszweig S1 und damit über das induktive Element 10 fließen kann. Dadurch ergibt sich während dieser Betriebsphase keine Ansteuerung des induktiven Elements 10 bzw. des Aktors 100.

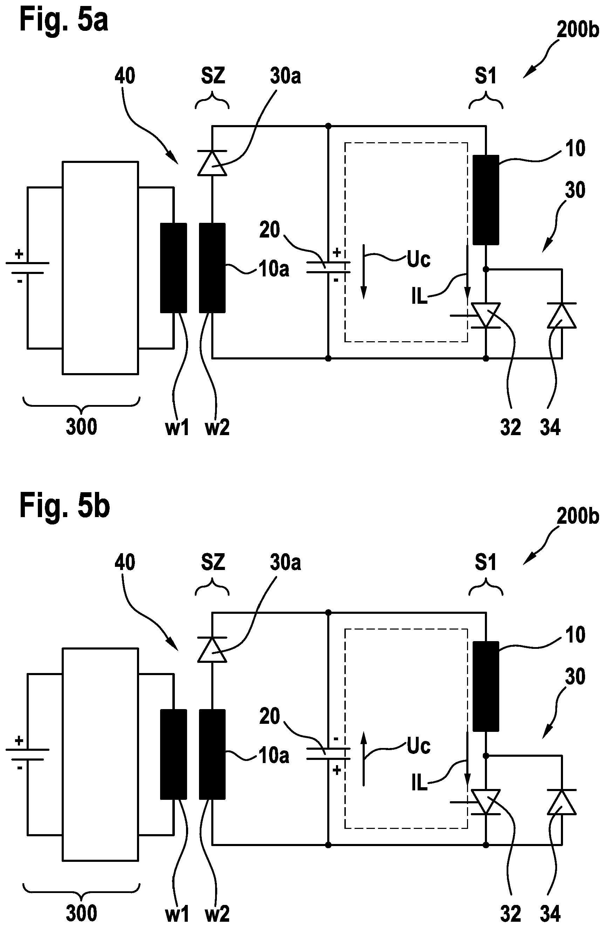

Eine weitere bevorzugte Ausführungsform 200b der erfindungsgemäßen Vorrichtung ist in Figur 5a abgebildet. Bei dieser Ausführungsform ist der erste Schaltungszweig wiederum mit dem Bezugszeichen S1 veranschaulicht. Die Schalteinrichtung 30 ist bei dieser Ausführungsform durch einen Thyristor 32 gebildet. Dem Thyristor 32 ist in an sich bekannter Weise vorteilhaft eine antiparallel geschaltete Diode 34 zugeordnet, welche einen Stromfluss über den Schaltungszweig S1 in Durchlassrichtung der Diode 34 ermöglicht, wenn der Thyristor 32 nicht leitend ist.

Ergänzend zu den vorstehend beschriebenen Ausführungsformen ist in Figur 5a eine Energieversorgungseinrichtung 300 abgebildet, die nicht notwendig Bestandteil der erfindungsgemäßen Vorrichtung 200b ist. Besonders bevorzugt ist ferner ein Transformator 40 vorgesehen, dessen Sekundärwicklung w2 vorteilhaft das weitere induktive Element 10a gemäß der vorstehenden Beschreibung bildet. Die weitere Schalteinrichtung 30a des weiteren Schaltungszweiges SZ ist vorliegend durch eine Diode gebildet.

Die Sekundärwicklung w2 des Transformators 40 ist bei einer bevorzugten Ausführungsform mit der Energieversorgungseinrichtung 300 derart verbunden, dass die Vorrichtung 300 die Primärwicklung w1 mit einer geeigneten Wechselspannung beaufschlagen kann. In diesem Fall kann durch den Transformator 40 elektrische Energie in an sich bekannter Weise auf die Sekundärwicklung w2 übertragen werden, wobei nur entsprechend positive Halbwellen der in der Sekundärwicklung w2 induzierten Spannung durch die Diode 30a durchgelassen werden. Mithin bildet die Konfiguration 300, 40, 10a, 30a einen Gleichspannungswandler, der zur Versorgung des Kondensators 20 mit elektrischer Energie ausgebildet ist.

Besonders bevorzugt dient die Sekundärwicklung w2 des Transformators 40 neben ihrer Funktion innerhalb des Transformators 40 gleichzeitig als induktives Element 10a gemäß den vorstehend beschriebenen Ausführungsformen. Das bedeutet, dass der Schaltungszweig SZ der in Figur 5a abgebildeten Ausführungsform zur zumindest temporären Speicherung von elektrischer Energie aus dem Kondensator 20 und damit für dessen Umladung von einer zweiten auf eine erste Polarität verwendbar ist.

In einem ersten Betriebszustand der Vorrichtung 200b gemäß Figur 5a und entsprechend einem ersten Zeitabschnitt gemäß Figur 3 zwischen dem Zeitpunkt t1 und dem Zeitpunkt tp1 weist die Kondensatorspannung Uc eine erste ("positive") Polarität auf und der Thyristor 32 ist leitend. Entsprechend ergibt sich ein über der Zeit t zunehmender "positiver" Spulenstrom IL durch das induktive Element 10, wie in Figur 5a dargestellt. Der Stromfluss ist wie folgt: Von dem Kondensator 20 über das induktive Element 10, über den Thyristor 32, und zurück zum Kondensator 20. Dabei nimmt die Kondensatorspannung Uc stetig ab bis auf einen Wert null. Somit wird elektrische Energie von dem Kondensator 20 auf das induktive Element 10 übertragen. Am Ende des in der Figur 5a dargestellten ersten Betriebszustands ist die elektrische Energie des Kondensators 20 null und die elektrische Energie des induktiven Elements 10 weist ein relatives Maximum auf.

In einem auf den ersten Betriebszustand unmittelbar folgenden zweiten Betriebszustand der Vorrichtung 200b gemäß Figur 5b und entsprechend einem zweiten Zeitabschnitt vergleichbar zu Figur 3 zwischen dem Zeitpunkt tp1 und dem Zeitpunkt tLC2 ist der Spulenstrom IL durch das induktive Element 10 "positiv" und der Thyristor 32 leitend. Entsprechend ergibt sich eine über der Zeit t zunehmende Kondensatorspannung Uc mit einer in Bezug auf die erste Polarität inversen ("negativen") Polarität. Der Stromfluss ist wie folgt: Von dem induktiven Element 10, über den Thyristor 32, in den Kondensator 20, und zurück zum induktiven Element 10. Dabei nimmt der Spulenstrom IL durch das induktive Element 10 stetig ab bis auf einen Wert null. Somit wird elektrische Energie von dem induktiven Element 10 auf den Kondensator 20 übertragen. Am Ende des in der Figur 5b dargestellten zweiten Betriebszustands ist die elektrische Energie des induktiven Elements 10 null und die elektrische Energie des Kondensators 20 weist ein relatives Maximum auf.

Bedingt durch die negative Polarität der Kondensatorspannung Uc kann in dem zweiten Betriebszustand - in Abhängigkeit von einem aktuell vorliegenden Wert einer Wechselspannung an der Sekundärwicklung w2 des Transformators 40 - die Diode 30a leiten, wodurch sich ein Stromfluss auch durch die Diode 30a und die Sekundärwicklung w2 ergeben kann. Dieser Stromfluss ist unter anderem abhängig von einer Induktivität und einem ohmschen Widerstand der Sekundärwicklung w2 und wird bei der Figur 5b der Einfachheit halber nicht mit betrachtet.

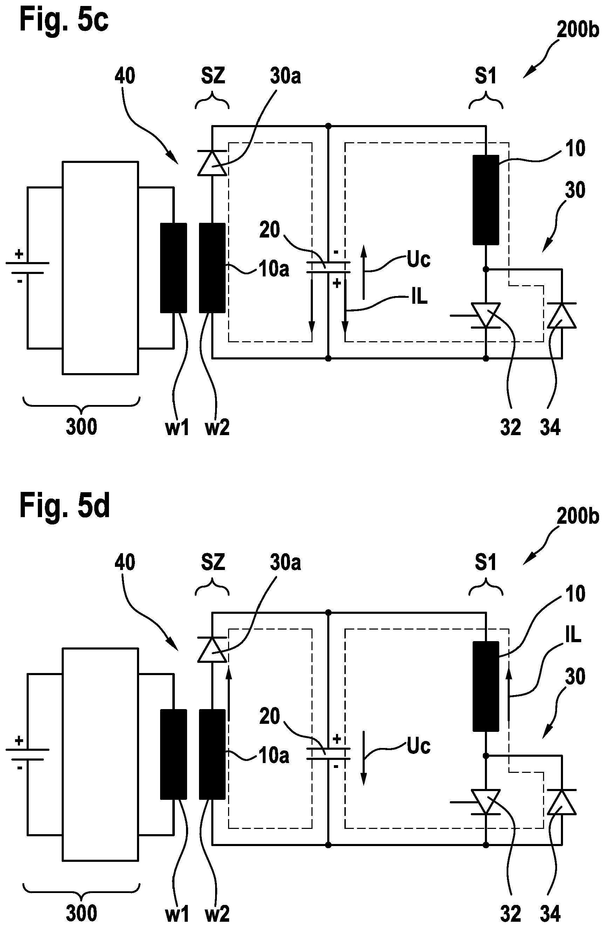

In einem auf den zweiten Betriebszustand unmittelbar folgenden dritten Betriebszustand der Vorrichtung 200b gemäß Figur 5c und entsprechend einem dritten Zeitabschnitt vergleichbar zu Figur 3 zwischen dem Zeitpunkt tLC2 und dem Zeitpunkt tp2 ist die Polarität der Kondensatorspannung Uc negativ. Der Thyristor 32 ist als Folge eines zu Beginn des dritten Betriebszustands vorliegenden vorübergehenden Nullwerts des Spulenstroms IL gesperrt. Die parallel zu dem Thyristor 32 geschaltete Diode 34 ist leitend. Entsprechend ergibt sich eine über der Zeit t abnehmende Kondensatorspannung Uc und ein über der Zeit t zunehmender negativer Spulenstrom IL. Der Stromfluss ist wie folgt: Von dem Kondensator 20, über die parallel zu dem Thyristor 32 geschaltete Diode 34, über das induktive Element 10, und zurück zu dem Kondensator 20. Dabei nimmt die Kondensatorspannung Uc stetig ab bis auf einen Wert null. Somit wird elektrische Energie von dem Kondensator 20 auf das induktive Element 10 übertragen.

Bedingt durch die negative Polarität der Kondensatorspannung Uc ergibt sich in dem dritten Betriebszustand ein weiterer Stromfluss wie folgt: Von der Sekundärwicklung w2 des Transformators 40, über die Diode 30a, über den Kondensator 20, und zurück zu der Sekundärwicklung w2. Am Ende des in der Figur 5c dargestellten dritten Betriebszustands ist die elektrische Energie des Kondensators 20 null und die elektrische Energie des induktiven Elements 10 weist ein relatives Maximum auf.

In einem auf den dritten Betriebszustand unmittelbar folgenden vierten Betriebszustand der Vorrichtung 200b gemäß Figur 5d und entsprechend einem vierten Zeitabschnitt vergleichbar zu Figur 3 zwischen dem Zeitpunkt tp2 und dem Zeitpunkt TLC ist der Spulenstrom IL negativ und der Thyristor 32 weiterhin gesperrt. Die Diode 34 ist weiterhin leitend. Es ergibt sich eine über der Zeit t zunehmende Kondensatorspannung Uc mit einer positiven Polarität. Der Stromfluss ist wie folgt: Von dem induktiven Element 10, über den Kondensator 20, über die parallel zu dem Thyristor 32 geschaltete Diode 34, und zurück zu dem induktiven Element 10. Dabei nimmt die Kondensatorspannung Uc stetig zu. Somit wird elektrische Energie von dem induktiven Element 10 auf den Kondensator 20 übertragen.

In Abhängigkeit von der aktuellen Kondensatorspannung Uc sowie dem aktuellen Wert der Wechselspannung an der Sekundärwicklung w2 ergibt sich in dem vierten Betriebszustand ein weiterer Stromfluss wie folgt: Von der Sekundärwicklung w2 des Transformators 40, über die Diode 30a, über den Kondensator 20, und zurück zu der Sekundärwicklung w2. Am Ende des in der Figur 5d dargestellten vierten Betriebszustands ist die elektrische Energie des induktiven Elements 10 zumindest in etwa null und die elektrische Energie des Kondensators 20 weist ein Maximum auf. Somit wird elektrische Energie von der Energieversorgungseinrichtung 300 auf den Kondensator 20 übertragen.

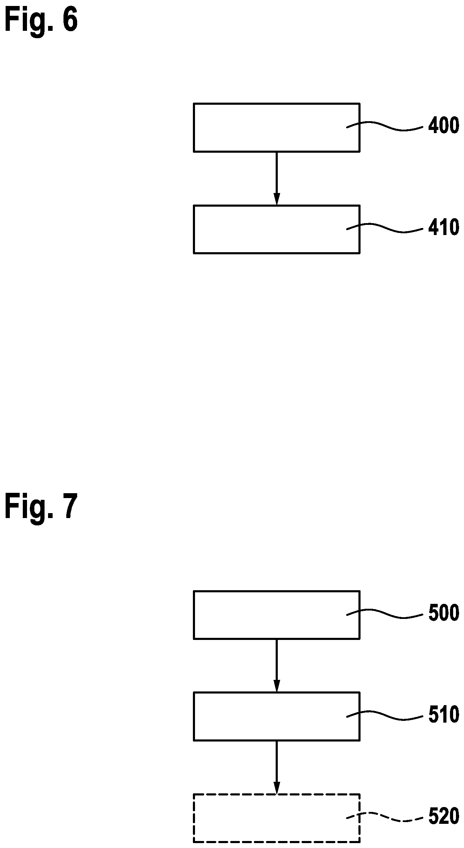

Figur 6 zeigt schematisch ein vereinfachtes Flussdiagramm einer Ausführungsform des erfindungsgemäßen Verfahrens. In einem ersten Schritt 400 wird die Schalteinrichtung 30 (Figur 1) in einen elektrisch leitenden Zustand versetzt, um eine Ansteuerung des induktiven Elements 10 und damit des Aktors 100 einzuleiten. In einem darauffolgenden Schritt 410 (Figur 6) wird die Schalteinrichtung 30 ausgehend von ihrem elektrisch leitenden Zustand in einen nicht elektrisch leitenden Zustand versetzt, um die Ansteuerung zu beenden. Erfindungsgemäß wird ein zweiter Zeitpunkt t2, der das Ende der vorstehend beschriebenen Ansteuerung definiert, so gewählt, dass in einem zwischen dem ersten und dem zweiten Zeitpunkt liegenden Zeitintervall T12 (Figur 3) die Kondensatorspannung Uc mindestens einmal ihre Polarität wechselt.

Sofern für eine nachfolgende Ansteuerung des induktiven Elements 10 die Polarität der Kondensatorspannung Uc nicht von Bedeutung ist, kann t2 beispielsweise auch zu etwa tLC2 gemäß Figur 3 gewählt werden. Eine zweite Ansteuerung erfolgt dann beispielsweise in dem Zeitintervall tLC2 bis etwa tLC, und so fort.

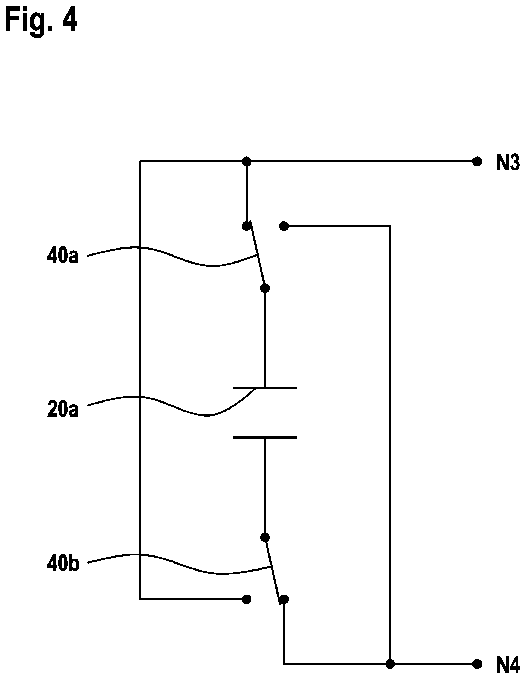

Sofern stets eine erste Polarität für die Ansteuerung des induktiven Elements 10 gewünscht ist, kann bei einer weiteren Ausführungsform auch eine Kommutierungseinrichtung 40a ,40b (Fig. 4) vorgesehen sein, um den die elektrische Ansteuerenergie speichernden Kondensator 20a zwischen den Schaltungsknotenpunkten N3, N4 zu kommutieren. Dadurch kann ein zunächst auf die zweite Polarität geladener Kondensator 20a durch entsprechendes umschalten der Schalteinrichtung 40a, 40b bezgl. der Schaltungsknotenpunkte N3, N4 in an sich bekannter Weise auf die gewünschte Polarität geschaltet werden, um eine Ansteuerung des induktiven Elements 10 (Figur 1) mit der gewünschten Polarität zu bewirken.

Alternativ kann bei einer weiteren Ausführungsform auch auf eine Kommutierungseinrichtung verzichtet werden. In diesem Fall wird der Zeitpunkt t2 so gewählt, dass die Kondensatorspannung in dem Zeitintervall t12 (Figur 3) mindestens (2*n) viele Male, also in einem einfachen Fall mindestens zweimal, ihre Polarität wechselt. In diesem Fall ist das Ende der ersten Ansteuerung bevorzugt etwa im Zeitbereich tLC gemäß Figur 3.

Figur 7 zeigt vereinfacht ein Flussdiagramm einer weiteren Ausführungsform des erfindungsgemäßen Verfahrens. In einem ersten Schritt 500 wird ein zunächst entladener Kondensator 20 bzw. 20a durch die Energieversorgungseinrichtung 300 (Figur 5a) auf eine Ausgansspannung Uc_1 (Figur 3) aufgeladen. Anschließend erfolgt in Schritt 510 (Figur 7) die erfindungsgemäße Ansteuerung des induktiven Elements 10. Bei einer Ausführungsform kann der Schritt 510 gemäß Figur 7 also in etwa den Verfahrensschritten 400, 410 gemäß Figur 6 entsprechen.

Anschließend erfolgt in Schritt 520 gemäß Figur 7 ein ggf. erforderliches Nachladen des Kondensators 20, 20a durch entsprechende Ansteuerung des Transformators 40 (Fig. 5a) durch die Energieversorgungseinrichtung 300. Sodann kann das erfindungsgemäße Verfahren bzw. die Ansteuerung des induktiven Elements 10a wiederholt werden.

Bei bevorzugten Ausführungsformen kann die Schalteinrichtung 30 bzw. 30a mindestens eine der folgenden Schaltkomponenten aufweisen: Thyristor, insulated gate, bipolar transistor, IGBT, Feldeffekttransistor, Schalter, Relais, Diode.

Die in Figur 4 abgebildeten Schaltereinrichtungen bzw. Umschalter 40a, 40b können einer Ausführungsform zufolge vorteilhaft auch als Halbleiterschalter bzw. als Vielzahl entsprechend konfigurierter und verschalteter Halbleiterschalter ausgebildet sein.

Bei einer weiteren Ausführungsform kann die Steuereinrichtung 210 so ausgebildet sein, dass sie die Umschalter 40a, 40b jeweils so ansteuert, das ein Kurzschluss des Kondensators 20a sicher ausgeschlossen wird.

Das erfindungsgemäße Prinzip ermöglicht vorteilhaft eine flexible Ansteuerung eines induktiven Elementes 10 beispielsweise eines elektromagnetischen Aktors 100, wie er beispielsweise in Einspritzventilen für Fluide einsetzbar ist.

Besonders bevorzugt eignet sich das erfindungsgemäße Prinzip auch zum impulsartigen Beaufschlagen eines elektromagnetischen Aktors 100, wobei maximale Pulsströme von etwa 1000 Ampere bzw. eine maximale Kondensatorspannung von etwa 1000 Volt denkbar sind. Dementsprechend ergeben sich entsprechende Pulsleistungen im Megawattbereich.

Bei einer weiteren bevorzugten Ausführungsform kann die Vorrichtung 200 so ausgebildet sein, dass sie den elektromagnetischen Aktor 100 etwa 200 mal je Sekunde mit der ersten Polarität impulsartig beaufschlagt, wobei eine einzige Ansteuerung (z.B. Zeitintervall T12 gemäß Figur 3) etwa 50 Mikrosekunden bis etwa 60 Mikrosekunden in Anspruch nehmen kann.

Besonders bevorzugt ermöglicht das erfindungsgemäße Prinzip eine weitgehende Rückgewinnung von für die Ansteuerung des induktiven Elements 10 verwendeter elektrischer Energie, sodass eine den Kondensator 20 wieder aufladende Energieversorgungseinrichtung 300 nur eine vergleichsweise geringe Nennleistung aufweisen muss bzw. eine Verlustleistung der erfindungsgemäßen Vorrichtung verhältnismäßig gering ist im Vergleich zu herkömmlichen Pulsentladungssystemen mit herkömmlichen Abkommutierkreisen bzw. Freilaufdioden.

Neben der Verwendung der Erfindung zur Ansteuerung elektromagnetischer Aktoren 100 ist auch der Einsatz zur elektrischen Energieversorgung von Pulslasersystem und dergleichen denkbar. Es ist zu beachten, dass das induktive Element 10 bzw. der elektromagnetische Aktor 100 nicht notwendig Bestandteil der erfindungsgemäßen Vorrichtung 200 ist. Dies ist in Figur 1 durch die gestrichelten Domänen 200, 100 veranschaulicht.

**Patentansprüche**

1. Verfahren zum Betreiben eines induktiven Elements (10), insbesondere eines elektromagnetischen Aktors (100), wobei ein Kondensator (20) vorgesehen ist, und wobei parallel zu dem Kondensator (20) eine erste Serienschaltung (S1) aus dem induktiven Element (10) und einer Schalteinrichtung (30) geschaltet ist, wobei die Schalteinrichtung (30) zu einem ersten Zeitpunkt (t1), zu dem eine Spannung (Uc) des Kondensators (20) einen einer ersten Polarität entsprechenden ersten Kondensatorspannungswert (Uc_1) aufweist, in einen elektrisch leitenden Zustand versetzt (400) wird, wobei die Schalteinrichtung (30) zu einem zweiten Zeitpunkt (t2) aus dem elektrisch leitenden Zustand in einen elektrisch nichtleitenden Zustand versetzt (410) wird, **dadurch gekennzeichnet, dass** der zweite Zeitpunkt (t2) so gewählt ist, dass die Kondensatorspannung (Uc) in einem zwischen dem ersten und dem zweiten Zeitpunkt liegenden Zeitintervall (T12) mindestens n-mal, wobei n > 1, ihre Polarität wechselt.

2. Verfahren nach Anspruch 1, wobei der zweite Zeitpunkt (t2) so gewählt ist, dass für das zweite Zeitintervall (T12) gilt: 0,7 * T_LC2 <= T_12 <= 1,3 * T_LC2, wobei T_12 der Wert des zweiten Zeitintervalls (T12) ist, wobei $T\_LC2 = \pi\sqrt{LC}$, wobei L ein Induktivitätswert des induktiven Elements (10) ist, und wobei C ein Kapazitätswert des Kondensators (20) ist.

3. Verfahren nach Anspruch 1, wobei der zweite Zeitpunkt (t2) so gewählt ist, dass die Kondensatorspannung (Uc) in dem Zeitintervall (T12) mindestens (2*n)-mal ihre Polarität wechselt.

4. Verfahren nach Anspruch 1 oder 3, wobei der zweite Zeitpunkt (t2) so gewählt ist, dass für das zweite Zeitintervall (T12) gilt: 0,8 * T_LC <= T_12 <= 1,2 * T_LC, wobei T_12 der Wert des zweiten Zeitintervalls (T12) ist, wobei $T\_LC = 2\pi\sqrt{LC}$, wobei L ein Induktivitätswert des induktiven Elements (10) ist, und wobei C ein Kapazitätswert des Kondensators (20) ist, wobei der zweite Zeitpunkt (t2) insbesondere so gewählt ist, dass 0,875 * T_LC <= T_12 <= 1,125 * T_LC.

5. Verfahren nach einem der vorstehenden Ansprüche, wobei der zweite Zeitpunkt (t2) so gewählt ist, dass ein Betrag des zu dem zweiten Zeitpunkt (t2) durch den Kondensator fließenden Stroms (IC_2) einen vorgebbaren Schwellwert unterschreitet.

6. Verfahren nach einem der vorstehenden Ansprüche, wobei der zweite Zeitpunkt (t2) so gewählt ist, dass ein Betrag der zu dem zweiten Zeitpunkt an dem Kondensator (20) anliegenden Spannung (Uc_2) einen vorgebbaren Schwellwert überschreitet.

7. Verfahren nach einem der vorstehenden Ansprüche, wobei mindestens ein weiterer Schaltungszweig (SZ) parallel zu dem Kondensator (20) geschaltet ist, wobei der mindestens eine weitere Schaltungszweig (SZ) wenigstens ein weiteres induktives Element (10a) aufweist und eine hierzu elektrisch in Serie geschaltete weitere Schalteinrichtung (30a).

8. Verfahren nach Anspruch 7, wobei die weitere Schalteinrichtung (30a) a) in einen elektrisch nichtleitenden Zustand versetzt wird, wenn die Kondensatorspannung (20) die erste Polarität aufweist, und/oder b) zumindest zeitweise, in einen elektrisch leitenden Zustand versetzt wird, wenn die Kondensatorspannung (20) eine zweite, von der ersten Polarität verschiedene Polarität, aufweist.

9. Verwendung des Verfahrens nach einem der vorstehenden Ansprüche zur Ansteuerung eines Einspritzventils insbesondere eines Kraftfahrzeugs.

10. Vorrichtung (200) zum Betreiben eines induktiven Elements (10), insbesondere eines elektromagnetischen Aktors (100), wobei ein Kondensator (20) vorgesehen ist, und wobei parallel zu dem Kondensator (20) eine erste Serienschaltung (S1) aus dem induktiven Element (10) und einer Schalteinrichtung (30) geschaltet ist, wobei die Vorrichtung (200) dazu ausgebildet ist, die Schalteinrichtung (30) zu einem ersten Zeitpunkt (t1), zu dem eine Spannung (Uc) des Kondensators (20) einen einer ersten Polarität entsprechenden ersten Kondensatorspannungswert (Uc_1) aufweist, in einen elektrisch leitenden Zustand zu versetzen, und die Schalteinrichtung (30) zu einem zweiten Zeitpunkt (t2) aus dem elektrisch leitenden Zustand in einen elektrisch nichtleitenden Zustand zu versetzen, **dadurch gekennzeichnet, dass** der zweite Zeitpunkt (t2) so gewählt ist, dass die Kondensatorspannung (Uc) in einem zwischen dem ersten und dem zweiten Zeitpunkt liegenden Zeitintervall (T12) mindestens n-mal, wobei n > 1, ihre Polarität wechselt.

11. Vorrichtung (200) nach Anspruch 10, wobei der zweite Zeitpunkt (t2) so gewählt ist, dass die Kondensatorspannung (Uc) in dem Zeitintervall (T12) mindestens (2*n)-mal ihre Polarität wechselt, wobei n>=1.

12. Vorrichtung (200) nach Anspruch 10 oder 11, wobei der zweite Zeitpunkt (t2) so gewählt ist, dass für das zweite-Zeitintervall (T12) gilt: 0,8 * T_LC <= T_12 <= 1,2 * T_LC, wobei T_12 der Wert des zweiten Zeitintervalls (T12) ist, wobei $T\_LC = 2\pi\sqrt{LC}$, wobei L ein Induktivitätswert des induktiven Elements (10) ist, und wobei C ein Kapazitätswert des Kondensators (20) ist, wobei der zweite Zeitpunkt (t2) insbesondere so gewählt ist, dass 0,875 * T_LC <= T_12 <= 1,125 * T_LC.

**13.** Vorrichtung (200) nach einem der Ansprüche 10 bis 12, wobei mindestens ein weiterer Schaltungszweig (SZ) parallel zu dem Kondensator (20) geschaltet ist, wobei der mindestens eine weitere Schaltungszweig (SZ) wenigstens ein weiteres induktives Element (10a) aufweist und eine hierzu elektrisch in Serie geschaltete weitere Schalteinrichtung (30a).

**14.** Vorrichtung (200) nach Anspruch 13, wobei ein Transformator (40) zur Versorgung des Kondensators (20) mit elektrischer Energie vorgesehen ist, und wobei das weitere induktive Element (10a) zumindest teilweise durch eine Sekundärwicklung des Transformators (40) gebildet ist.

**15.** Vorrichtung (200) nach einem der Ansprüche 10 bis 14, wobei mindestens eine der Schalteinrichtungen (30, 30a) mindestens eine der folgenden Schaltkomponenten (32) aufweist: Thyristor, insulated gate bipolar transistor, IGBT, Feldeffekttransistor, Schalter, Relais, Diode.

**16.** Vorrichtung (200) nach Anspruch 15, wobei eine Diode (34) parallel zu der Schaltkomponente (32) der ersten Serienschaltung (S1) geschaltet ist.

**Claims**

**1.** Method for operating an inductive element (10), in particular an electromagnetic actuator (100), wherein a capacitor (20) is provided, and wherein a first series circuit (S1) composed of the inductive element (10) and a switching device (30) is connected in parallel with the capacitor (20), wherein the switching device (30) is transferred (400) to an electrically conducting state at a first time (t1) at which a voltage (Uc) of the capacitor (20) has a first capacitor voltage value (Uc_1) corresponding to a first polarity, wherein the switching device (30) is transferred (410) from the electrically conducting state to an electrically non-conducting state at a second time (t2), **characterized in that** the second time (t2) is selected so that the capacitor voltage (Uc) changes its polarity at least n times, wherein n > 1, in a time interval (T12) located between the first and the second time.

**2.** Method according to Claim 1, wherein the second time (t2) is selected so that the following holds true for the second time interval (T12): 0.7 * T_LC2 <= T_12 <= 1.3 * T_LC2, wherein T_12 is the value of the second time interval (T12), wherein T_LC2 = $\Pi\sqrt{LC}$, wherein L is an inductance value of the inductive element (10), and wherein C is a capacitance value of the capacitor (20).

**3.** Method according to Claim 1, wherein the second time (t2) is selected so that the capacitor voltage (Uc) changes its polarity at least (2*n) times in the time interval (T12).

**4.** Method according to Claim 1 or 3, wherein the second time (t2) is selected so that the following holds true for the second time interval (T12) : 0.8 * T_LC <= T_12 <= 1.2 * T_LC, wherein T_12 is the value of the second time interval (T12), wherein T_LC = $2\Pi\sqrt{LC}$, wherein L is an inductance value of the inductive element (10), and wherein C is a capacitance value of the capacitor (20), wherein the second time (t2) is selected, in particular, so that 0.875 * T_LC <= T_12 <= 1.125 * T_LC.

**5.** Method according to one of the preceding claims, wherein the second time (t2) is selected so that a magnitude of the current (IC_2) flowing through the capacitor at the second time (t2) undershoots a prescribable threshold value.

**6.** Method according to one of the preceding claims, wherein the second time (t2) is selected so that a magnitude of the voltage (Uc_2) applied to the capacitor (20) at the second time exceeds a prescribable threshold value.

**7.** Method according to one of the preceding claims, wherein at least one further circuit branch (SZ) is connected in parallel with the capacitor (20), wherein the at least one further circuit branch (SZ) has at least one further inductive element (10a) and a further switching device (30a) electrically connected in series therewith.

**8.** Method according to Claim 7, wherein the further switching device (30a) a) is transferred to an electrically non-conducting state when the capacitor voltage (20) has the first polarity and/or b) is transferred at least temporarily to an electrically conducting state when the capacitor voltage (20) has a second polarity different from the first polarity.

**9.** Use of the method according to one of the preceding claims for actuating an injection valve, in particular of a motor vehicle.

**10.** Apparatus (200) for operating an inductive element (10), in particular an electromagnetic actuator (100), wherein a capacitor (20) is provided, and wherein a first series circuit (S1) composed of the inductive element (10) and a switching device (30) is connected in parallel with the capacitor (20), wherein the apparatus (200) is configured to transfer the switching device (30) to an electrically conducting state at a first time (t1) at which a voltage (Uc) of the capacitor (20) has a first capacitor voltage value (Uc_1) corresponding to a first polarity, and to transfer the switching device (30) from the electrically conducting state to an electrically non-conducting state at a second time (t2), **characterized in that** the second time (t2) is selected so that the capacitor voltage (Uc) changes its polarity at least n times, wherein n > 1, in a time interval (T12) located between the first and the second time.

11. Apparatus (200) according to Claim 10, wherein the second time (t2) is selected so that the capacitor voltage (Uc) changes its polarity at least (2*n) times in the time interval (T12), wherein n >= 1.

12. Apparatus (200) according to Claim 10 or 11, wherein the second time (t2) is selected so that the following holds true for the second time interval (T12): 0.8 * T_LC <= T_12 <= 1.2 * T_LC, wherein T_12 is the value of the second time interval (T12), wherein T_LC = 2Π√LC, wherein L is an inductance value of the inductive element (10), and wherein C is a capacitance value of the capacitor (20), wherein the second time (t2) is selected, in particular, so that 0.875 * T_LC <= T_12 <= 1.125 * T_LC.

13. Apparatus (200) according to one of Claims 10 to 12, wherein at least one further circuit branch (SZ) is connected in parallel with the capacitor (20), wherein the at least one further circuit branch (SZ) has at least one further inductive element (10a) and a further switching device (30a) electrically connected in series therewith.

14. Apparatus (200) according to Claim 13, wherein a transformer (40) is provided for supplying electrical energy to the capacitor (20), and wherein the further inductive element (10a) is formed at least partly by a secondary winding of the transformer (40).

15. Apparatus (200) according to one of Claims 10 to 14, wherein at least one of the switching devices (30, 30a) has at least one of the following switching components (32): thyristor, insulated-gate bipolar transistor, IGBT, field-effect transistor, switch, relay, diode.

16. Apparatus (200) according to Claim 15, wherein a diode (34) is connected in parallel with the switching component (32) of the first series circuit (S1).

**Revendications**

1. Procédé pour faire fonctionner un élément inductif (10), notamment un actionneur électromagnétique (100), dans lequel il est prévu un condensateur (20), et dans lequel un premier circuit série (S1) constitué de l'élément inductif (10) et d'un moyen de commutation (30) est monté en parallèle avec le condensateur (20), dans lequel le moyen de commutation (30) est placé dans un état électriquement conducteur (400) à un premier instant (t1) auquel une tension (Uc) du condensateur (20) présente une première valeur de tension de condensateur (Uc_1) correspondant à une première polarité, dans lequel le moyen de commutation (30) est placé d'un état électriquement conducteur dans un état électriquement non conducteur (410) à un second instant (t2), **caractérisé en ce que** le second instant (t2) est choisi de manière à ce que, au cours d'un intervalle de temps (T12) situé entre les premier et second instants, la tension de condensateur (Uc) change au moins n fois de polarité, avec n >1.

2. Procédé selon la revendication 1, dans lequel le second instant (t2) est choisi de manière à ce que pendant le deuxième intervalle de temps (T12), on ait : 0,7*T_LC2 <= T_12 <= 1,3*T_LC2, où T_12 est la valeur du second intervalle de temps (T12), où

   $$\mathrm{T\_LC2} = \pi\sqrt{LC},$$ où L est une valeur d'inductance de l'élément inductif (10), et où C est une valeur de capacité du condensateur (20).

3. Procédé selon la revendication 1, dans lequel le second instant (t2) est sélectionné de manière à ce que la tension de condensateur (Uc), au cours de l'intervalle de temps (T12), change au moins (2*n) fois de polarité.

4. Procédé selon la revendication 1 ou 3, dans lequel le second instant (t2) est choisi de manière à ce que, pendant le deuxième intervalle de temps (T12), on ait : 0,8*T_LC <= T_12 <= 1,2*T_LC, où T_12 est la valeur du second intervalle de temps (T12), où T_LC

   $$= 2\pi\sqrt{LC},$$ où L est une valeur d'inductance de l'élément inductif (10), et où C est une valeur de capacité du condensateur (20), dans lequel le second instant (t2) est notamment sélectionné de manière à ce que 0,875*T_LC <= T_12 <= 1,125*T_LC.

5. Procédé selon l'une des revendications précédentes, dans lequel le second instant (t2) est choisi de manière à ce qu'une valeur du courant passant à travers le condensateur (IC_2) jusqu'à l'instant (t2) s'abaisse en dessous d'une valeur de seuil pouvant être prédéfinie.

**6.** Procédé selon l'une des revendications précédentes, dans lequel le second instant (t2) est choisi de manière à ce qu'une valeur de la tension (Uc_2) appliquée au condensateur (20) jusqu'au second instant s'abaisse en dessous d'une valeur de seuil pouvant être prédéfinie.

**7.** Procédé selon l'une des revendications précédentes, dans lequel au moins une autre branche de circuit (SZ) est montée en parallèle avec le condensateur (20), dans lequel l'au moins une autre branche de circuit (SZ) comporte au moins un autre élément inductif (10a) et un autre moyen de commutation (30a) monté en série avec celui-ci.

**8.** Procédé selon la revendication 7, dans lequel l'autre moyen de commutation (30a) a) est placé dans un état électriquement non conducteur lorsque la tension de condensateur (20) présente la première polarité, et/ou b) est placé au moins par instants dans un état électriquement conducteur lorsque la tension de condensateur (20) présente une seconde polarité différente de la première polarité.

**9.** Utilisation du procédé selon l'une des revendications précédentes pour commander une soupape d'injection, notamment d'un véhicule automobile.

**10.** Dispositif (200) pour faire fonctionner un élément inductif (10), notamment un actionneur électromagnétique (100), dans lequel il est prévu un condensateur (20), et dans lequel un premier circuit série (S1) constitué de l'élément inductif (10) et d'un moyen de commutation (30) est monté en parallèle avec le condensateur (20), dans lequel le dispositif (200) est conçu pour placer le moyen de commutation (30) dans un état électriquement conducteur à un premier instant (t1) auquel une tension (Uc) du condensateur (20) présente une première valeur de tension de condensateur (Uc_1) correspondant à une première polarité, et pour placer le moyen de commutation (30) de l'état électriquement conducteur à un état électriquement non conducteur à un second instant (t2), **caractérisé en ce que** le second instant (t2) est choisi de manière à ce que, au cours d'un intervalle de temps (T12) situé entre les premier et second instants, la tension de condensateur (Uc) change au moins n fois de polarité, avec n > 1.

**11.** Dispositif (200) selon la revendication 10, dans lequel le second instant (t2) est choisi de manière à ce que, au cours de l'intervalle de temps (T12), la tension de condensateur (Uc) change au moins (2*n) fois de polarité, avec n > = 1.

**12.** Dispositif (200) selon la revendication 10 ou 11, dans lequel le second instant (t2) est choisi de manière à ce que, au cours du second intervalle de temps (T12), on ait : 0,8*T_LC <= T_12 <= 1,2*T_LC, où T_12 est la valeur du second intervalle de temps (T12), où $T\_LC = 2\pi\sqrt{LC}$, T_LC où L est une valeur d'inductance de l'élément inductif (10), et où C est une valeur de capacité du condensateur (20), dans lequel le second instant (t2) est notamment sélectionné de manière à ce que 0,875*T_LC <= T_12 <= 1,125*T_LC.

**13.** Dispositif (200) selon l'une des revendications 10 à 12, dans lequel au moins une autre branche de circuit (SZ) est montée en parallèle avec le condensateur (20), dans lequel l'au moins une autre branche de circuit (SZ) comporte au moins un autre élément inductif (10a) et un autre moyen de commutation (30a) monté électriquement en série avec celui-ci.

**14.** Dispositif (200) selon la revendication 13, dans lequel il est prévu un transformateur (40) pour alimenter le condensateur (20) en énergie électrique, et dans lequel l'autre élément inductif (10a) est formé au moins en partie par un enroulement secondaire du transformateur (40).

**15.** Dispositif (200) selon l'une des revendications 10 à 14, dans lequel au moins l'un des moyens de commutation (30, 30a) comporte au moins l'un des composants de commutation (32) suivants : un thyristor, un transistor bipolaire à grille isolée, IGBT, un transistor à effet de champ, un commutateur, un relais, une diode.

**16.** Dispositif (200) selon la revendication 15, dans lequel une diode (34) est montée en parallèle avec les composants de commutation (32) du premier circuit série (S1).

# Fig. 1

# Fig. 2

# Fig. 3

EP 3 033 582 B1

## Fig. 4

EP 3 033 582 B1

# Fig. 5a

# Fig. 5b

16

## Fig. 5c

## Fig. 5d

# Fig. 6

400

410

# Fig. 7

500

510

520

**EP 3 033 582 B1**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 3405327 A

- RU 2351064 C1